(19) Europäisches Patentamt
European Patent Office
Office européen des brevets

(11) **EP 3 633 700 A1**

(12) **DEMANDE DE BREVET EUROPEEN**

(43) Date de publication:
**08.04.2020 Bulletin 2020/15**

(51) Int Cl.:
*H01F 27/28* (2006.01)     *H01F 27/36* (2006.01)
*H01F 27/40* (2006.01)     *H05K 1/02* (2006.01)
*H05K 1/18* (2006.01)     *H05K 9/00* (2006.01)
*H02M 7/00* (2006.01)     *H01F 27/29* (2006.01)

(21) Numéro de dépôt: **19201201.1**

(22) Date de dépôt: **02.10.2019**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **05.10.2018 FR 1859267**

(71) Demandeur: **Brightloop**
**75020 Paris (FR)**

(72) Inventeur: **LIFFRAN, Florent**
**75009 PARIS (FR)**

(74) Mandataire: **Lavaud, Thomas et al**
**Cabinet Boettcher**
**16, rue Médéric**
**75017 Paris (FR)**

(54) **DISPOSITIF DE TRANSFORMATION COMPRENANT UN TRANSFORMATEUR ET DES COMPOSANTS ÉLECTRIQUES**

(57) Dispositif de transformation comportant un transformateur, des premiers composants électriques (4) et des moyens de connexion, le transformateur comprenant un premier bobinage et un deuxième bobinage, les premiers composants électriques étant connectés via les moyens de connexion entre des premières bornes du premier bobinage, les premiers composants électriques s'étendant sur une surface d'intégration (35) située entre les moyens de connexion, la surface d'intégration, les moyens de connexion et une portion du premier bobinage formant des portions de circulation d'une première boucle de circulation de courant, le dispositif de transformation étant agencé pour qu'un courant de connexion circule dans la première boucle de circulation de courant, chaque portion de circulation étant plus large que longue selon la direction de circulation du courant de connexion.

Fig. 2

EP 3 633 700 A1

Printed by Jouve, 75001 PARIS (FR)

**Description**

L'invention concerne le domaine des dispositifs de transformation comprenant un transformateur et des composants électriques.

ARRIERE PLAN DE L'INVENTION

Une alimentation à découpage formant un convertisseur DC/DC comporte classiquement un transformateur à haute fréquence permettant de réaliser un isolement galvanique et d'apporter un rapport de transformation sur la tension et le courant. Le transformateur comprend des bobinages formant au moins un enroulement primaire et au moins un enroulement secondaire, et un circuit magnétique permettant leur couplage.

Outre la sécurité et la fiabilité, les concepteurs d'une alimentation à découpage cherchent à optimiser d'une part le rendement de conversion, et d'autre part la densité de puissance.

Ces deux objectifs sont toutefois liés par le fait que si un rendement élevé permet de réduire la consommation d'énergie pour une même puissance de sortie, il permet surtout de réduire les pertes générées et donc le volume et le poids des moyens de refroidissement nécessaires pour limiter les échauffements. L'obtention d'un rendement élevé est donc un atout important pour optimiser la densité de puissance de l'alimentation à découpage.

La principale variable influant sur la compacité de l'alimentation à découpage est sa fréquence de découpage. L'utilisation d'une haute fréquence de découpage tend à réduire l'énergie stockée dans les éléments réactifs, inductances et condensateurs, et par là même d'en réduire le volume.

Cependant, une fréquence de découpage élevée a un impact négatif sur le rendement à cause des pertes par commutation dans les composants de commutation (transistors, diodes), qui sont proportionnelles à cette fréquence, et sur le niveau de pertes en général. Le niveau de pertes est en effet augmenté à cause de l'accroissement, à haute fréquence, de l'importance relative des capacités parasites, et de l'augmentation de la résistance électrique des conducteurs. L'augmentation de la résistance électrique d'un conducteur traversé par un courant à haute fréquence est due aux effets de « peau » et de « proximité ».

L'effet de peau résulte du fait qu'un conducteur, parcouru par un courant alternatif, génère un champ magnétique qui, par rétroaction, tend à recréer un courant compensant le courant initial, avec pour conséquence de « chasser » le courant alternatif dans la périphérie du conducteur. Ainsi, plus la fréquence de découpage est élevée, moins la densité de courant au centre du conducteur est importante, ce qui augmente la résistance électrique équivalente. Cet effet existe également entre deux conducteurs adjacents, lorsque le champ magnétique créé par le courant dans un conducteur affecte la répartition du courant dans le second : on parle alors d'effet de proximité.

L'impact des effets de peau et de proximité dans le transformateur d'une alimentation à découpage est très pénalisant.

Lorsque l'on souhaite augmenter la puissance et donc le courant fournis par une alimentation à découpage sans en pénaliser le rendement, il convient d'augmenter la section des conducteurs pour réduire leur résistance électrique. Cependant, à haute fréquence, le courant ne pénètre pas dans le cœur des conducteurs à cause des effets de peau et de proximité, et l'augmentation de la section des conducteurs est inopérante.

On comprend donc qu'il est compliqué d'augmenter la puissance fournie par une alimentation à découpage tout en conservant son rendement et sa compacité.

Pour atténuer les effets de peau et de proximité, l'état de l'art est de tenter de compenser les ampères-tours générés entre différents conducteurs formant des enroulements adjacents du transformateur au moyen d'arrangements géométriques astucieux.

Parmi les techniques connues, on peut citer les fils de Litz qui sont fabriqués en tressant des brins isolés électriquement entre eux, dont le diamètre est inférieur à la valeur de l'épaisseur de peau à la fréquence de découpage. Chaque brin unitaire étant alternativement à l'intérieur puis à l'extérieur du fil, le champ magnétique qu'il créé se compense avec celui des autres brins.

Il est également possible d'entrelacer les différents enroulements d'un transformateur pour compenser progressivement le champ magnétique créé par chaque enroulement.

Ces solutions, malgré une inévitable pénalité de foisonnement pour la première (la section effective d'un fil de Litz est d'autant inférieure à celle d'un conducteur « plein » de diamètre extérieur équivalent que les brins unitaires sont fins) et de capacité parasite pour la seconde, se révèlent relativement efficaces pour atténuer les effets de peau et de proximité dans les bobinages du transformateur. Cependant, ces bénéfices disparaissent à l'extérieur des bobinages, dès lors qu'il faut créer des connexions. Les pertes dues aux hautes fréquences dans les connexions entre les bobinages et les composants reliés au transformateur sont alors importantes, et le rendement global du transformateur et de l'alimentation à découpage s'en trouve significativement réduit. Ce phénomène explique par ailleurs en partie les différences de rendement observées entre les calculs théoriques et les mesures expérimentales, la localisation expérimentale de ces pertes étant très difficile à réaliser de façon fiable et précise.

OBJET DE L'INVENTION

L'invention a pour objet d'augmenter le rendement d'un dispositif de transformation comprenant un transformateur et des composants électriques reliés au transformateur, sans pour autant augmenter le volume du dispositif de transformation.

RESUME DE L'INVENTION

En vue de la réalisation de ce but, on propose un dispositif de transformation comportant un transformateur, des premiers composants électriques et des moyens de connexion, le transformateur comprenant un premier bobinage et un deuxième bobinage, l'un des premier bobinage et deuxième bobinage formant au moins un enroulement primaire et l'autre des premier bobinage et deuxième bobinage formant au moins un enroulement secondaire, les premiers composants électriques étant connectés via les moyens de connexion entre des premières bornes du premier bobinage, les premiers composants électriques s'étendant sur une surface d'intégration située entre les moyens de connexion, la surface d'intégration, les moyens de connexion et une portion du premier bobinage formant des portions de circulation d'une première boucle de circulation de courant, le dispositif de transformation étant agencé pour qu'un courant de connexion circule dans la première boucle de circulation de courant, chaque portion de circulation étant plus large que longue selon une direction de circulation du courant de connexion.

En mettant en œuvre la première boucle de circulation de courant qui est plus large que longue, on réduit les pertes associées à la circulation du courant de connexion dans les premiers composants électriques et dans les moyens de connexion qui relient les premiers composants électriques au premier bobinage. Les pertes sont donc réduites dans des zones dans lesquelles les techniques de réduction évoquées plus tôt ne sont pas applicables. On augmente ainsi de manière importante le rendement du dispositif de transformation selon l'invention.

On propose aussi une alimentation à découpage comprenant un dispositif de transformation tel que celui qui vient d'être décrit.

On propose en outre un équipement électrique comprenant un boîtier dans lequel est intégrée l'alimentation à découpage.

D'autres caractéristiques et avantages de l'invention ressortiront à la lecture de la description qui suit d'un mode de réalisation particulier non limitatif de l'invention.

BREVE DESCRIPTION DES DESSINS

Il sera fait référence aux dessins annexés, parmi lesquels :

- la figure 1 représente un schéma électrique simplifié d'une alimentation à découpage intégrant le dispositif de transformation selon l'invention ;
- la figure 2 est une vue en perspective et de dessus du dispositif de transformation, un premier circuit imprimé étant représenté partiellement transparent ;
- la figure 3 est une vue en perspective et de dessus du premier circuit imprimé et d'un circuit magnétique du dispositif de transformation ;
- la figure 4 est une vue en section du dispositif de transformation.

DESCRIPTION DETAILLEE DE L'INVENTION

Le dispositif de transformation selon l'invention est ici utilisé dans une alimentation à découpage formant un convertisseur DC/DC.

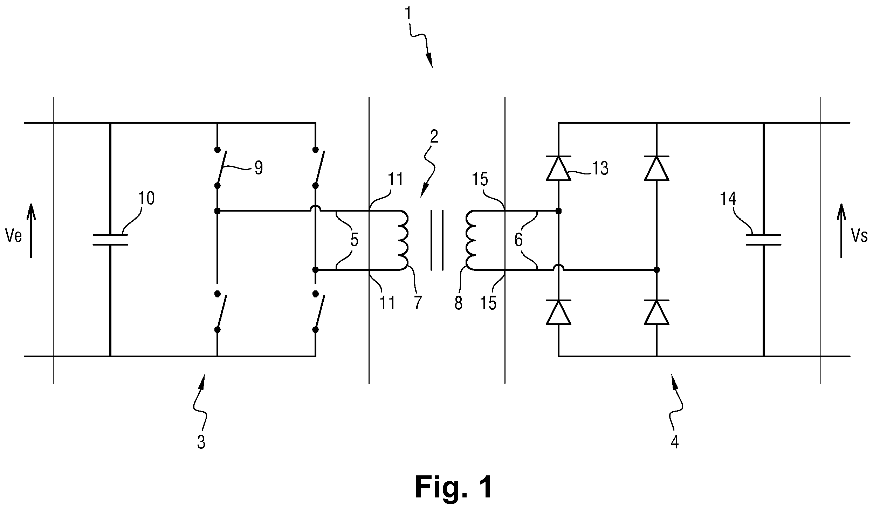

En référence à la figure 1, le dispositif de transformation 1 comporte un transformateur 2, des composants électriques primaires 3, des composants électriques secondaires 4, des moyens de connexion primaires 5 et des moyens de connexion secondaires 6.

Le transformateur 2 comprend un bobinage primaire formant au moins un enroulement primaire 7 et un bobinage secondaire formant au moins un enroulement secondaire 8.

Par « bobinage », on entend ici un ou plusieurs conducteur(s) de tout type enroulé(s) pour former un circuit électrique. Chaque conducteur peut être un fil électrique, une barre, une feuille, une piste gravée sur un circuit imprimé, etc.

Bien qu'un seul enroulement primaire 7 et un seul enroulement secondaire 8 soient représentés sur la figure 1, le bobinage primaire du transformateur 2 comporte ici cinq enroulements primaires 7 et le bobinage secondaire comporte ici cinq enroulements secondaires 8. Un courant secondaire, circulant dans le bobinage secondaire, est ici cinq fois supérieur à un courant primaire circulant dans le bobinage primaire.

Les composants électriques primaires 3 comprennent une pluralité de transistors 9 et un condensateur de filtrage primaire 10. Par « condensateur de filtrage », on entend ici tout condensateur réalisant tout type de filtrage. Un « condensateur de filtrage » peut par exemple être un condensateur de découplage. Les composants électriques primaires 3 sont connectés entre des bornes primaires 11 du bobinage primaire via les moyens de connexion primaires 5.

Les composants électriques secondaires 4 comprennent des diodes 13 et un condensateur de filtrage secondaire 14. Les composants électriques secondaires 4 sont connectés entre des bornes secondaires 15 du bobinage secondaire via les moyens de connexion secondaires 6.

De manière classique et bien connue, une tension continue d'entrée Ve est découpée (ou hachée) par les transistors 9 et appliquée entre les bornes primaires 11. Une tension continue de sortie Vs est alors produite après redressement et filtrage.

Bien sûr, le schéma de la figure 1 et le fonctionnement décrits sont extrêmement simplifiés par rapport au schéma et au fonctionnement réels de l'alimentation à découpage.

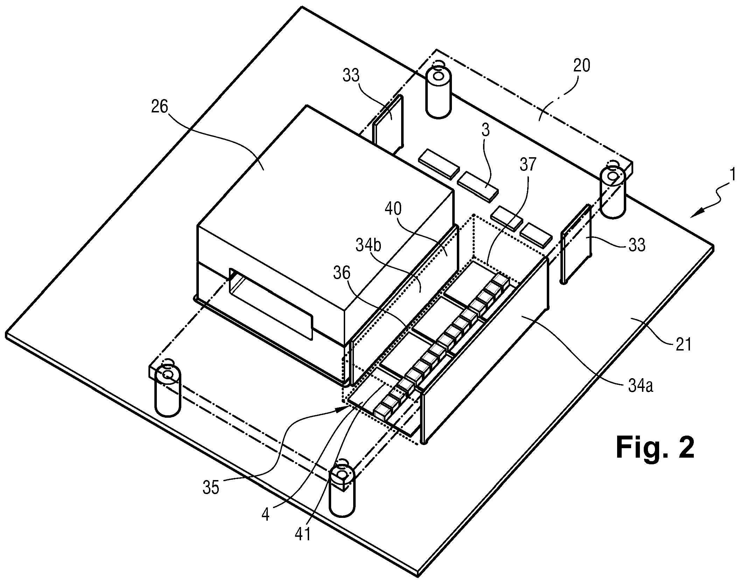

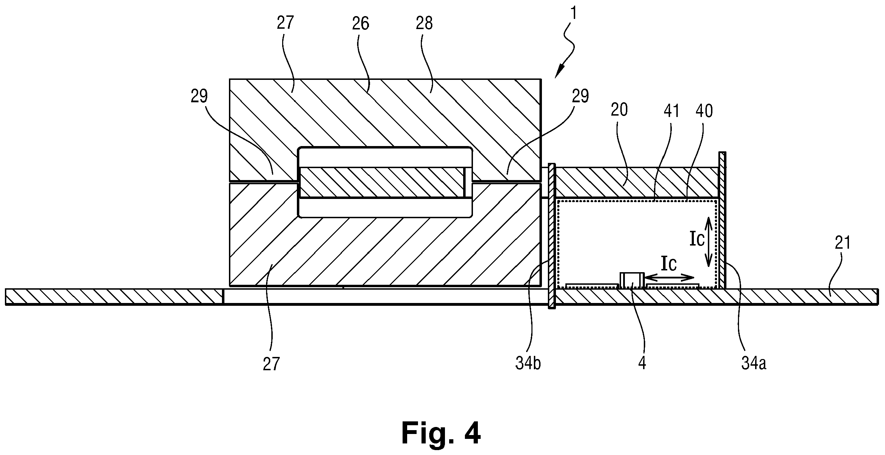

En référence aux figures 2 à 4, le dispositif de transformation selon l'invention 1 est ici réalisé sur un premier circuit imprimé 20 et sur un deuxième circuit imprimé 21.

Le transformateur 2 est ici du type « planar ».

Le bobinage primaire et le bobinage secondaire du transformateur 2 comprennent des pistes 23 formant des spires gravées sur différentes couches du premier circuit imprimé 20.

Le premier circuit imprimé 20 comporte dix couches comprenant cinq couches primaires et cinq couches secondaires. Un enroulement primaire 7 est formé sur chaque couche primaire. Un enroulement secondaire 8 est formé sur chaque couche secondaire. Les cinq couches primaires et les cinq couches secondaires sont superposées de manière alternée : une couche primaire est positionnée entre deux couches secondaires, et une couche secondaire entre deux couches primaires (sauf pour la couche supérieure et la couche inférieure).

Les couches primaires sont connectées entre elles en série ou en parallèle, de façon à former les enroulements primaires 7 en fonction du rapport de transformation souhaité. De même, les couches secondaires sont connectées entre elles en série ou en parallèle pour former les enroulements secondaires 8.

Le transformateur 2 comporte de plus un circuit magnétique, en l'occurrence un noyau de ferrite 26, à l'intérieur duquel s'étendent au moins partiellement le bobinage primaire et le bobinage secondaire.

Le noyau de ferrite 26 comprend deux portions de noyau 27 identiques. Chaque portion de noyau 27 comprend une base 28 et deux branches 29 qui s'étendent perpendiculairement à la base 28, chaque portion de noyau 27 présentant ainsi une section en C. Les deux portions de noyau 27 sont positionnées l'une contre l'autre mais en sens inverse, de sorte que la surfaces de l'extrémité libre de chaque branche 29 d'une portion de noyau 27 soit en appui contre la surface de l'extrémité libre d'une branche 29 de l'autre portion de noyau 27. Le noyau de ferrite 26, lorsqu'il est assemblé, présente la forme d'un tube de sections extérieure et intérieure rectangulaires, l'épaisseur des parois du tube étant proche de la dimension d'un petit côté de la section intérieure. On note qu'il serait possible d'aménager un entrefer dans le circuit magnétique, par exemple en intercalant une cale d'entrefer entre les deux portions de noyau 27.

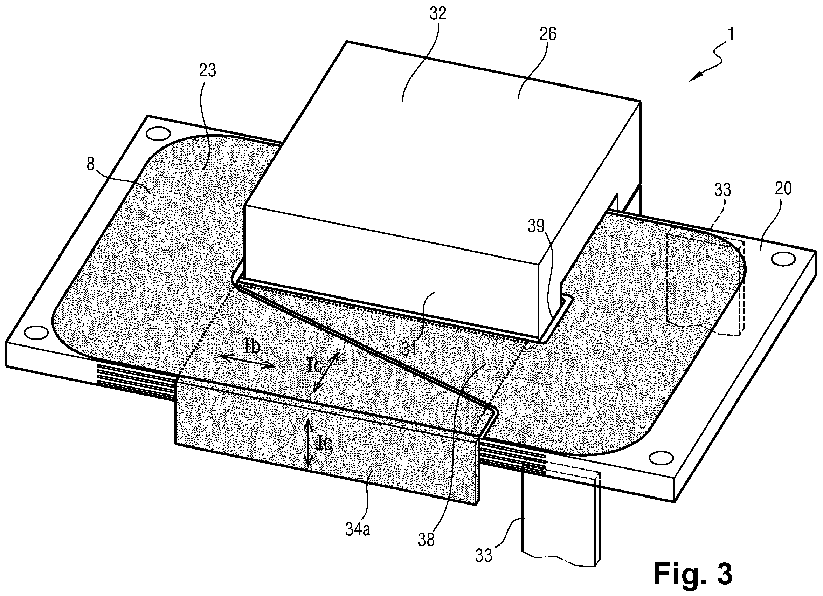

Le premier circuit imprimé 20 comporte un orifice 39 positionné dans une portion centrale du premier circuit imprimé 20. Les enroulements primaires 7 et les enroulements secondaires 8 s'étendent autour de l'orifice 39, comme on le voit sur la figure 3, où un enroulement secondaire 8 « supérieur » est représenté.

Le noyau de ferrite 26 est positionné par rapport au premier circuit imprimé 20 de sorte qu'une paroi latérale 31 du noyau de ferrite 26 s'étende dans l'orifice 39 orthogonalement au premier circuit imprimé 20, que l'autre paroi latérale s'étende à l'extérieur du premier circuit imprimé 20, et que la paroi supérieure 32 et la paroi inférieure du noyau de ferrite 26 s'étendent chacune d'un côté du premier circuit imprimé 20 parallèlement à celui-ci. La zone de jonction entre les deux portions de noyau 27 du noyau de ferrite 26 se trouve ici au milieu d'une épaisseur du premier circuit imprimé 20.

Le premier circuit imprimé 20 et le deuxième circuit imprimé 21 sont montés parallèlement l'un par rapport à l'autre et sont fixés entre eux à l'aide de moyens de fixation classiques : plots, entretoises, boulons, vis etc.

Les composants électriques primaires 3 et les composants électriques secondaires 4 sont ici montés sur le deuxième circuit imprimé 21.

Les moyens de connexion primaires 5, via lesquels les composants électriques primaires 3 sont connectés aux bornes primaires 11, comportent deux languettes conductrices primaires 33 qui s'étendent verticalement entre le premier circuit imprimé 20 et le deuxième circuit imprimé 21.

Les deux languettes conductrices primaires 33 présentent toutes deux une forme rectangulaire. Le courant circule dans les languettes conductrices primaires 33 selon une direction verticale, c'est à dire perpendiculairement au premier circuit imprimé 20 et au deuxième circuit imprimé 21. Dans cette description, on distingue la « longueur » et la « largeur » d'une surface de la manière suivante : la longueur correspond à la dimension de la surface selon une direction parallèle au courant qui parcourt ladite surface, et la largeur correspond à la dimension de la surface selon une direction perpendiculaire au courant qui parcourt ladite surface.

Les languettes conductrices primaires 33 sont ici plus longues que larges.

Les composants primaires 3 sont positionnés sur une surface du deuxième circuit imprimé 21 qui s'étend entre les languettes conductrices primaires 33.

Les moyens de connexion secondaires 6, via lesquels les composants électriques secondaires 4 sont connectés aux bornes secondaires 15, comportent deux languettes conductrices secondaires 34 qui s'étendent verticalement entre le premier circuit imprimé 20 et le deuxième circuit imprimé 21.

Les deux languettes conductrices secondaires 34 présentent toutes deux une forme rectangulaire. Le courant circule dans les languettes conductrices secondaires 34 selon une direction verticale, c'est à dire perpendiculairement au premier circuit imprimé 20 et au deuxième circuit imprimé 21.

Les languettes conductrices secondaires 34 sont ici plus larges que longues.

Les composants électriques secondaires 4 sont situés dans une zone d'intégration présentant un volume délimité en longueur et en largeur par une longueur et une largeur d'un ensemble de bobinage formé par le bobinage primaire et le bobinage secondaire, et en hauteur par une hauteur du circuit magnétique 26.

Les composants électriques secondaires 4 s'étendent ici sur une surface d'intégration 35 du deuxième circuit imprimé 21. La surface d'intégration 35 est située entre les languettes conductrices secondaires 34. La surface d'intégration 35 présente une forme générale rectangulaire et est délimitée par des premiers côtés 36 parallèles aux segments constituant les intersections des languettes conductrices secondaires 34 et du deuxième circuit imprimé 21, et par des deuxièmes côtés 37 perpendiculaires aux premiers côtés 36.

La dimension des premiers côtés 36 est plus importante que celle des deuxièmes côtés 37.

On décrit maintenant plus en détail la circulation des courants dans le bobinage secondaire, dans les languettes conductrices secondaires 34 et dans les composants électriques secondaires 4. Ces courants sont des courants à haute fréquence.

Le courant secondaire qui circule dans le bobinage secondaire est en réalité formé par la somme d'une pluralité de courants qui circulent chacun dans des directions distinctes. Parmi ces courants, on distingue un courant de bobinage Ib et un courant de connexion Ic.

Le courant de bobinage Ib circule dans le bobinage secondaire selon une direction parallèle localement aux spires formant le bobinage secondaire.

Le courant de connexion Ic est le courant qui circule dans les composants électriques secondaires 4 et dans les languettes conductrices secondaires 34.

Une direction de circulation du courant de bobinage Ib est orthogonale à une direction de circulation du courant de connexion Ic. Plus précisément, une composante principale du courant de bobinage Ic est orthogonale localement, au moins dans une zone située à proximité des jonctions entre les languettes conductrices secondaires 34 et le bobinage secondaire, à une composante principale du courant de connexion Ic. On note que l'on parle de « direction » de circulation et non de « sens » de circulation, car les courants sont des courants alternatifs dont le sens est inversé régulièrement à la fréquence desdits courants.

Le courant de connexion Ic circule donc dans la surface d'intégration 35 parallèlement aux deuxièmes côtés 37 de la surface d'intégration 35, dans une première languette conductrice secondaire 34a parallèlement à la longueur de la première languette conductrice secondaire 34a, dans les composants secondaires 4, dans une portion 38 du bobinage secondaire, et dans une deuxième languette conductrice secondaire 34b parallèlement à la longueur de la deuxième languette conductrice secondaire 34b.

Le courant de connexion Ic circule ainsi dans une boucle de circulation de courant 40 formée par une pluralité de portions de circulation. Les portions de circulation comprennent la première languette conductrice secondaire 34a, la deuxième languette conductrice secondaire 34b, la portion 38 du bobinage secondaire et la surface d'intégration 35.

La boucle de circulation de courant 40 présente une forme cylindrique, dont une section dans un plan perpendiculaire à un axe longitudinal de la forme cylindrique est un rectangle de circulation 41. On peut aussi considérer que la boucle de circulation de courant 40 présente une forme parallélépipédique : sa surface est celle d'un parallélépipède auquel on aurait supprimé deux faces en regard (les deux faces délimitées par le rectangle de circulation 41 et qui sont perpendiculaires à la fois aux languettes conductrices secondaires 34 et au premier circuit imprimé 20).

Les faces de la forme cylindrique sont formées par les portions de circulation de la boucle de circulation de courant 40.

Le rectangle de circulation 41 s'étend dans une épaisseur du premier circuit imprimé 20, du deuxième circuit imprimé 21 et des languettes conductrices secondaires 34. Les deux grands côtés du rectangle de circulation 41 ont pour dimension celle de la longueur de la surface d'intégration 35 (c'est à dire d'un deuxième côté 37), et les deux petits côtés du rectangle de circulation 41 ont pour dimension celle de la longueur des languettes conductrices secondaires 34 (ou celle de la distance entre le premier circuit imprimé 20 et le deuxième circuit imprimé 21).

Le périmètre P du rectangle de circulation 41 est tel que :

$$P \leq 1,6.L$$, où L est une largeur des languettes conductrices secondaires 34.

La largeur des languettes conductrices secondaires 34 est donc relativement importante par rapport au périmètre P du rectangle de circulation 41.

Comme on l'a vu plus tôt, la dimension des premiers côtés 36 de la surface d'intégration 35 est plus importante que celle des deuxièmes côtés 37 : la surface d'intégration 35 est plus large que longue.

De même, la longueur des languettes conductrices secondaires 34 est nettement inférieure à leur largeur.

Ainsi, la longueur de chaque portion de circulation de la boucle de circulation de courant 40 est inférieure à la largeur de ladite portion de circulation.

Cette configuration est particulièrement avantageuse. En minimisant la longueur totale de la boucle de circulation de courant 40, et en augmentant le rapport entre la largeur et la longueur de ladite boucle de circulation de courant 40, on réduit de manière importante la résistance dans les moyens de connexion secondaires 6 (c'est à dire dans les languettes conductrices secondaires 34), et dans les composants électriques situés à proximité et reliés au bobinage secondaire, c'est à dire dans les composants électriques secondaires 4.

En réduisant cette résistance, on réduit les pertes dues aux courants à haute fréquence dans les zones qui viennent d'être évoquées, à l'extérieur du bobinage secondaire, dans lesquelles les techniques de réduction des pertes de l'art antérieur ne peuvent être mises en œuvre. On augmente ainsi grandement le rendement du dispositif de transformation selon l'invention.

Bien entendu, l'invention n'est pas limitée au mode de réalisation décrit mais englobe toute variante entrant dans le champ de l'invention telle que définie par les revendications.

On a décrit ici que la surface d'intégration, sur laquelle sont montés les composants électriques secondaires, est située sur le deuxième circuit imprimé. La surface d'intégration pourrait très bien être située sur le premier circuit imprimé, de sorte que le bobinage primaire, le bobinage secondaire et la surface d'intégration soient positionnés sur le même premier circuit imprimé. Le bobinage primaire et le bobinage secondaire pourraient aussi être seulement partiellement formés sur le premier circuit imprimé.

L'invention est ici mise en œuvre avec des premiers composants électriques, en l'occurrence les composants électriques secondaires, et un premier bobinage, en l'occurrence le bobinage secondaire. On pourrait aussi mettre en œuvre l'invention avec les composants électriques primaires et le bobinage primaire : les premiers composants électriques sont alors les composants électriques primaires et le premier bobinage est le bobinage primaire.

Avantageusement, l'invention peut être mise en œuvre à la fois avec les composants électriques primaires et le bobinage primaire, et avec les composants électriques secondaires et le bobinage secondaire. On définit alors, d'une part, les premiers composants électriques, le premier bobinage, et une première boucle de circulation de courant, et d'autre part, des deuxièmes composants électriques connectés entre des deuxièmes bornes d'un deuxième bobinage, et une deuxième boucle de circulation de courant semblable à la première boucle de circulation de courant. La deuxième boucle de circulation de courant est ainsi formée par une deuxième surface d'intégration, des deuxièmes moyens de connexion et une portion du deuxième bobinage, chaque portion de circulation de la deuxième boucle de circulation de courant étant plus large que longue.

Le transformateur décrit ici est un transformateur planar comportant des bobinages comprenant des spires formées sur un circuit imprimé. Le transformateur peut bien sûr être différent. Les bobinages du transformateur peuvent par exemple être formés de fils conducteurs enroulés. Le transformateur pourrait aussi comprendre un premier bobinage (primaire ou secondaire) comprenant des spires formées sur un circuit imprimé, et un deuxième bobinage formé de fil(s) conducteur(s) enroulé(s). Le transformateur serait ainsi partiellement formé sur un circuit imprimé.

On n'a pas, dans cette description, évoqué de composants électriques autres que les composants électriques primaires et les composants électriques secondaires et montés sur le premier circuit imprimé et/ou sur le deuxième circuit imprimé. Il est bien sûr possible que d'autres composants soient situés sur le premier circuit imprimé et/ou sur le deuxième circuit imprimé, et il est possible aussi que ce ne soit pas le cas. Le dispositif de transformation peut ainsi être intégré sur un ou plusieurs circuits imprimés d'un équipement électrique qui ne sont pas uniquement dédiés à cette fonction, ou bien peut être intégré sur un ou plusieurs circuits imprimés dédiés à cette fonction. Dans ce dernier cas, on peut parfaitement prévoir que le dispositif de transformation se présente sous la forme d'un unique composant intégré, chaque exemplaire de composant intégré pouvant alors éventuellement être associé à un unique numéro de série (*serial number*) et à un unique numéro de pièce (*part number*).

Le circuit magnétique peut bien sûr être différent de celui présenté ici. Il peut s'agir par exemple d'un noyau d'un matériau quelconque comprenant deux portions de noyau ayant chacune une section en E.

**Revendications**

1. Dispositif de transformation comportant un transformateur (2), des premiers composants électriques (4) et des moyens de connexion (6), le transformateur comprenant un premier bobinage et un deuxième bobinage, l'un des premier bobinage et deuxième bobinage formant au moins un enroulement primaire (7) et l'autre des premier bobinage et deuxième bobinage formant au moins un enroulement secondaire (8), les premiers composants électriques étant connectés via les moyens de connexion entre des premières bornes (15) du premier bobinage, les premiers composants électriques s'étendant sur une surface d'intégration (35) située entre les moyens de connexion, la surface d'intégration, les moyens de connexion et une portion du premier bobinage formant des portions de circulation d'une première boucle de circulation de courant (40), le dispositif de transformation étant agencé pour qu'un courant de connexion (Ic) circule dans la première boucle de circulation de courant, chaque portion de circulation étant plus large que longue selon une direction de circulation du courant de connexion (Ic).

2. Dispositif de transformation selon la revendication 1, un courant de bobinage circulant dans le premier bobinage, le premier bobinage et les moyens de connexions étant agencés de sorte qu'une direction de circulation du courant de bobinage (Ib) est orthogonale à la direction de circulation du courant de connexion (Ic).

3. Dispositif de transformation selon l'une des revendications précédentes, le transformateur comprenant un circuit magnétique (26) à l'intérieur duquel s'étendent au moins partiellement le premier bobinage et le deuxième bobinage, la surface d'intégration (35) étant située dans une zone d'intégration présentant un volume délimité en longueur et en largeur par une longueur et une largeur d'un ensemble de bobinage formé par le premier bobinage et le deuxième bobinage, et en hauteur par une hauteur du circuit magnétique (26).

**4.** Dispositif de transformation selon l'une des revendications précédentes, dans lequel le premier bobinage et le deuxième bobinage sont au moins partiellement formés sur un circuit imprimé, et dans lequel la surface d'intégration est située sur ledit circuit imprimé.

**5.** Dispositif de transformation selon l'une des revendications 1 à 3, dans lequel le premier bobinage et le deuxième bobinage sont au moins partiellement formés sur un premier circuit imprimé (20), et dans lequel la surface d'intégration (35) est située sur un deuxième circuit imprimé (21) parallèle au premier circuit imprimé (20) .

**6.** Dispositif de transformation selon la revendication 5, dans lequel les moyens de connexion comportent deux languettes conductrices (34) reliant le premier circuit imprimé et le deuxième circuit imprimé, la surface d'intégration s'étendant entre les deux languettes conductrices (34), une section de la première boucle de circulation de courant (40) étant un rectangle de circulation (41) qui s'étend dans une épaisseur du premier circuit imprimé, du deuxième circuit imprimé et des languettes conductrices.

**7.** Dispositif de transformation selon la revendication 6, dans lequel un périmètre P du rectangle de circulation (41) est tel que :

$$P \leq 1,6.L$$

L étant une largeur des languettes conductrices (34).

**8.** Dispositif de transformation selon l'une des revendications précédentes, comportant en outre des deuxièmes composants électriques connectés entre des deuxièmes bornes du deuxième bobinage, le dispositif de transformation comportant une deuxième boucle de circulation de courant semblable à la première boucle de circulation de courant.

**9.** Dispositif de transformation selon l'une des revendications précédentes, le premier bobinage formant au moins un enroulement secondaire, les premiers composants électriques (4) comprenant des diodes de redressement (13) et un condensateur de filtrage (14) appartenant, tout comme le transformateur, à une alimentation à découpage.

**10.** Dispositif de transformation selon l'une des revendications 1 à 8, le premier bobinage formant au moins un enroulement primaire, les premiers composants électriques comprenant des transistors de découpage (9) et un condensateur de filtrage (10) appartenant, tout comme le transformateur, à une alimentation à découpage.

**11.** Alimentation à découpage comprenant un dispositif de transformation selon l'une des revendications 9 ou 10.

**12.** Equipement électrique comprenant un boîtier dans lequel est intégrée l'alimentation à découpage selon la revendication 11.

**Fig. 1**

Fig. 2

**Fig. 3**

Fig. 4

Europäisches
Patentamt

European
Patent Office

Office européen
des brevets

# RAPPORT DE RECHERCHE EUROPEENNE

Numéro de la demande

EP 19 20 1201

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2009/085702 A1 (ZENG JIANHONG [CN] ET AL) 2 avril 2009 (2009-04-02) | 1-5,8-12 | INV. |
| A | * figures 4,5a,5b * <br> * alinéa [0025] * <br> * alinéa [0026] * <br> ----- | 6,7 | H01F27/28 <br> H01F27/36 <br> H01F27/40 <br> H05K1/02 <br> H05K1/18 |
| A | US 2018/138801 A1 (CHEN RUNRUO [US]) 17 mai 2018 (2018-05-17) * figure 1 * <br> ----- | 9 | H05K9/00 <br> H02M7/00 <br> H01F27/29 |
| A | US 2006/152318 A1 (ISURIN ALEXANDER [US] ET AL) 13 juillet 2006 (2006-07-13) * figure 5 * <br> ----- | 10 | |
| A | US 2018/069485 A1 (HSIAO YUNG-HUNG [TW] ET AL) 8 mars 2018 (2018-03-08) * figures 13,15 * <br> ----- | 1 | |
| A | US 2018/182527 A1 (FUJITA SATORU [JP]) 28 juin 2018 (2018-06-28) * figures 4,5a * <br> ----- | 1 | DOMAINES TECHNIQUES RECHERCHES (IPC) |
| A | US 2016/197557 A1 (NAMBA AKIHIRO [JP] ET AL) 7 juillet 2016 (2016-07-07) * figures 10,12 * <br> ----- | 1 | H01F <br> H05K <br> H02M |
| A | US 2009/309684 A1 (TSAI SHENG-NAN [TW] ET AL) 17 décembre 2009 (2009-12-17) * figure 5 * <br> * alinéa [0023] * <br> ----- | 1 | |

Le présent rapport a été établi pour toutes les revendications

| Lieu de la recherche | Date d'achèvement de la recherche | Examinateur |
|---|---|---|
| Munich | 30 janvier 2020 | Rouzier, Brice |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 19 20 1201

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

30-01-2020

| Document brevet cité au rapport de recherche | | Date de publication | Membre(s) de la famille de brevet(s) | | Date de publication |
|---|---|---|---|---|---|
| US 2009085702 | A1 | 02-04-2009 | TW<br>US | 200915362 A<br>2009085702 A1 | 01-04-2009<br>02-04-2009 |
| US 2018138801 | A1 | 17-05-2018 | CN<br>EP<br>JP<br>US<br>US<br>WO | 110326207 A<br>3539206 A1<br>2019534674 A<br>2018138801 A1<br>2018278174 A1<br>2018089771 A1 | 11-10-2019<br>18-09-2019<br>28-11-2019<br>17-05-2018<br>27-09-2018<br>17-05-2018 |
| US 2006152318 | A1 | 13-07-2006 | CA<br>EP<br>US | 2532771 A1<br>1681690 A2<br>2006152318 A1 | 12-07-2006<br>19-07-2006<br>13-07-2006 |
| US 2018069485 | A1 | 08-03-2018 | US<br>US | 2018069485 A1<br>2018076726 A1 | 08-03-2018<br>15-03-2018 |
| US 2018182527 | A1 | 28-06-2018 | JP<br>US | 2018110477 A<br>2018182527 A1 | 12-07-2018<br>28-06-2018 |
| US 2016197557 | A1 | 07-07-2016 | JP<br>JP<br>US<br>WO | 6114660 B2<br>2015041959 A<br>2016197557 A1<br>2015025579 A1 | 12-04-2017<br>02-03-2015<br>07-07-2016<br>26-02-2015 |
| US 2009309684 | A1 | 17-12-2009 | TW<br>US | 200952002 A<br>2009309684 A1 | 16-12-2009<br>17-12-2009 |

EPO FORM P0460

Pour tout renseignement concernant cette annexe : voir Journal Officiel de l'Office européen des brevets, No.12/82